# EUROPEAN PATENT APPLICATION

(11) **EP 1 291 904 A2**
(43) Date of publication of application: **12.03.2003**
(21) Application number: 02019861.0
(22) Date of filing: 09.09.2002
(51) Int. Cl.: H01L 21/20, C30B 29/38

(54) **GaN substrate formed over GaN layer having discretely formed minute holes produced by selective growth**

(30) Priority: 10.09.2001 JP 2001272895; 09.05.2002 JP 2002134089
(71) Applicant: Fuji Photo Film Co., Ltd., Kanagawa-ken (JP)
(72) Inventor: Kuniyasu, Toshiaki, Kaisei-machi, Kanagawa-ken (JP); Wada, Mitsugu, Kaisei-machi, Kanagawa-ken (JP); Fukunaga, Toshiaki, Kaisei-machi, Kanagawa-ken (JP)
(74) Representative: Klunker . Schmitt-Nilson . Hirsch

(57) **Abstract**

In a process for producing a substrate for use in a semiconductor element: a growth suppression mask which is constituted by a plurality of mask elements being discretely arranged and each having a width of 2.5 micrometers or smaller is formed on a surface of a base substrate; a first GaN layer having a plurality of holes is formed on the surface of the base substrate by growing GaN from areas of the surface of the base substrate which are not covered by the plurality of first mask elements; and a second GaN layer is formed over the first GaN layer by crystal growth.

## Description

### BACKGROUND OF THE INVENTION

### Field of the Invention

The present invention relates to a substrate which is used in a semiconductor element. The present invention also relates to a process for producing a substrate which is used in a semiconductor element. The present invention further relates to a semiconductor element which uses the above substrate.

### Description of the Related Art

Japanese Journal of Applied Physics Vol. 37 (1998) Part 2, pp. L1020 discloses a short-wavelength semiconductor laser device which emits laser light in the 410 nm band. This semiconductor laser device is produced as follows. First, a GaN layer is formed on a sapphire substrate, a stripe pattern of a SiO₂ film is formed on the GaN layer, and a GaN thick film is formed by selective lateral growth from nuclei of the growth generated in stripe areas of the GaN layer which are not covered by the stripe pattern of the SiO₂ mask. Then, a GaN substrate is obtained by separating the GaN thick film from the sapphire substrate. Next, an n-type GaN buffer layer, an n-type InGaN crack prevention layer, an n-type AlGaN/GaN modulation doped superlattice cladding layer, an n-type GaN optical waveguide layer, an n-InGaN/InGaN multiple-quantum-well active layer, a p-type AlGaN carrier block layer, a p-type GaN optical waveguide layer, a p-type AlGaN/GaN modulation doped superlattice cladding layer, and a p-type GaN contact layer are formed on the above GaN substrate. However, the highest output power obtained in the fundamental transverse mode by the above semiconductor laser devices is about 30 mW, and the semiconductor laser device is reliable in the output power range up to 30 mW.

Since the conventional ELOG (epitaxial lateral overgrowth) substrates as above are produced by selective lateral growth from nuclei of the growth generated in stripe areas of a GaN layer which are not covered by SiO₂ mask, defects are reduced in the region produced by the selective lateral growth of GaN.

Nevertheless, according to the conventional method as above, the density of the nuclei for growth is high, and therefore the spaces between the nuclei are bridged before the grown nuclei become large. Thus, defects are likely to be produced in the bridged regions. Although the GaN thick film is required to have a certain thickness in order to use the GaN thick film as a substrate, the defect density is increased with increase in the thickness. Even when the defect densities in the bridged regions are low, the defect density increases with the increase in the thickness, Consequently, it is difficult to form a wide low-defect region. That is, the conventional ELOG substrates have only a small low-defect region.

In order to realize a reliable semiconductor laser device, an optical waveguide is required to be formed on a low-defect region of a substrate. Therefore, the conventional ELOG substrates are effective for producing semiconductor laser devices having a narrow stripe structure as disclosed in the aforementioned reference. However, it is impossible to form a reliable semiconductor laser device having a broad stripe structure on the conventional ELOG substrates.

In order to realize a reliable semiconductor laser device having high output power, the semiconductor laser device is required to have a broad stripe structure, and in order to realize a reliable semiconductor laser device having a broad stripe structure, the semiconductor laser device is required to be formed on a GaN substrate which includes a wide low-defect region, instead of the conventional ELOG substrates.

Generally, reliability of any semiconductor elements constituted by semiconductor layers formed on a substrate, including semiconductor laser devices, depends on defect densities in the substrate. Therefore, a substrate including a wide low-defect region is required for every type of semiconductor element.

### SUMMARY OF THE INVENTION

An object of the present invention is to provide a substrate which is used in a semiconductor element, and in which the defect density is low in a wide region.

Another object of the present invention is to provide process for producing a substrate which is used in a semiconductor element, and in which the defect density is low in a wide region.

A further object of the present invention is to provide a semiconductor element which uses a substrate in which the defect density is low in a wide region.
(1) According to the first aspect of the present invention, there is provided a process for producing a substrate for use in a semiconductor element, comprising the steps of: (a) forming on a surface of a base substrate a first growth suppression mask constituted by a plurality of first mask elements being discretely arranged and each having a width of 2.5 micrometers or smaller; (b) forming on the surface of the base substrate a first GaN layer having a plurality of holes by growing GaN from areas of the surface of the base substrate which are not covered by the plurality of first mask elements; and (c) forming a second GaN layer over the first GaN layer.
   Preferably, the process according to the first aspect of the present invention may have one or any possible combination of the following additional features (i) to (iii).
   (i) The process according to the first aspect of the present invention may further comprise, between the steps (b) and (c), a step for removing the first growth suppression mask.
   (ii) The process according to the first aspect of the present invention may further comprise, after the step (c), the steps of: (d) forming on the second GaN layer a second growth suppression mask constituted by a plurality of second mask elements being discretely arranged and each having a width of 2.5 micrometers or smaller; (e) forming on the second GaN layer a third GaN layer having a plurality of holes by growing GaN from areas of the second GaN layer which are not covered by the plurality of second mask elements; and (f) forming a fourth GaN layer over the third GaN layer.
   (iii) The process according to the first aspect of the present invention having the feature (ii) may further comprise, between the steps (e) and (f), a step for removing the first growth suppression mask.
(2) According to the second aspect of the present invention, there is provided a process for producing a substrate for use in a semiconductor element by formation of a plurality of substrate layers on a surface of a base substrate, where the formation is realized by at least one predetermined sequence of operations, and each of the at least one predetermined sequence of operations includes the steps of: (a) forming on a base surface a growth suppression mask constituted by a plurality of mask elements being discretely arranged and each having a width of 2.5 micrometers or smaller; (b) forming on the base surface a first GaN layer having a plurality of holes by growing GaN from areas of the base surface which are not covered by the plurality of mask elements; and (c) forming a second GaN layer over the first GaN layer.
   That is, the above predetermined sequence of operations including the steps (a) to (c) may be performed once or a plurality of times. In each sequence of operations, a group of layers including the growth suppression mask, the first GaN layer, and the second GaN layer are formed. When the predetermined sequence of operations is performed a plurality of times, a plurality of groups of layers each including the growth suppression mask, the first GaN layer, and the second GaN layer are stacked. In the above description of the second aspect of the present invention, the base surface referred to in step (a) is a surface of the base substrate when the first group of layers are formed directly on the surface of the base substrate, and the base surface referred to in step (a) is a surface of the second GaN layer in a precedingly formed group of layers when a group of layers are formed on the precedingly formed group of layers.
   Preferably, the process according to the second aspect of the present invention may have one or any possible combination of the following additional features (i) to (viii).
   (i) The process according to the second aspect of the present invention may further comprise, between the steps (b) and (c), a step for removing the second growth suppression mask.
   (ii) The distance between each of the plurality of mask elements and one of the plurality of mask elements nearest to each of the plurality of mask elements is equal to or smaller than 2.5 micrometers.
   (iii) In the process according to the second aspect of the present invention, the plurality of mask elements cover 40 to 90% of the entire base surface.
   (iv) In the process according to the second aspect of the present invention, the growth suppression mask is made of a dielectric material. The dielectric material is, for example, SiO₂, Al₂O₃, or SiN.
   (v) The process according to the second aspect of the present invention may further comprise a step for forming as an uppermost layer of the substrate a conductive GaN layer which is doped with a conductive impurity.
   (vi) In the process according to the second aspect of the present invention, the at least a portion of the base substrate including the surface is made of one of GaN, sapphire, SiC, ZnO, LiGaO₂, LiAlO₂, ZrB₂, GaAs, GaP, Ge, and Si.
   (vii) The process according to the second aspect of the present invention may further comprise a step for removing the base substrate.
   (viii) The process according to the second aspect of the present invention may further comprise a step of separating an uppermost one of the plurality of layers from the other of the plurality of layers.
(3) According to the third aspect of the present invention, there is provided a substrate for use in a semiconductor element, comprising: a base substrate; a first GaN layer having a plurality of holes which are discretely arranged and being formed on a surface of the base substrate by growing GaN from areas of the surface of the base substrate which are not covered by a plurality of first mask elements constituting a first growth suppression mask, being discretely arranged, and each having a width of 2.5 micrometers or smaller; and a second GaN layer formed over the first GaN layer.
   The substrate according to the third aspect of the present invention may further comprise: a third GaN layer having a plurality of holes which are discretely arranged and being formed on a surface of the second GaN layer by growing GaN from areas of the surface of the second GaN layer which are not covered by a plurality of second mask elements constituting a second growth suppression mask, being discretely arranged, and each having a width of 2.5 micrometers or smaller; and a fourth GaN layer formed over the third GaN layer.
(4) According to the fourth aspect of the present invention, there is provided a substrate for use in a semiconductor element, comprising a base substrate and a plurality of substrate layers formed on the base substrate, and the plurality of substrate layers include at least one group of layers. Each of the at least one group of layers includes: a first GaN layer having a plurality of holes which are discretely arranged and being formed on a base surface by growing GaN from areas of the base surface which are not covered by a plurality of mask elements constituting a growth suppression mask, being discretely arranged, and each having a width of 2.5 micrometers or smaller; and a second GaN layer formed over the first GaN layer.
   Preferably, the substrate according to the fourth aspect of the present invention may have one or any possible combination of the following additional features (i) to (v).
   (i) The distance between each of the plurality of mask elements and one of the plurality of mask elements nearest to each of the plurality of mask elements is equal to or smaller than 2.5 micrometers.
   (ii) The plurality of mask elements cover 40 to 90% of the entire base surface.
   (iii) The growth suppression mask is made of a dielectric material.
   (iv) The substrate according to the fourth aspect of the present invention further comprise a conductive GaN layer which is doped with a conductive impurity and formed as an uppermost layer of the substrate.
   (v) In the substrate according to the fourth aspect of the present invention, at least a portion of the base substrate including the surface of the base substrate is made of one of GaN, sapphire, SiC, ZnO, LiGaO₂, LiAlO₂, ZrB₂, GaAs, GaP, Ge, and Si.
(5) According to the fifth aspect of the present invention, there is provided a semiconductor element for use in a semiconductor element, comprising at least one group of substrate layers, where each of the at least one group of substrate layers includes: a first GaN layer having a plurality of holes which are discretely arranged and being formed on a base surface by growing GaN from areas of the base surface which are not covered by a plurality of mask elements constituting a growth suppression mask, being discretely arranged, and each having a width of 2.5 micrometers or smaller; and a second GaN layer formed over the first GaN layer.
(6) According to the sixth aspect of the present invention, there is provided a substrate for use in a semiconductor element, comprising a base substrate and a plurality of substrate layers formed on the base substrate. The plurality of substrate layers include at least one group of layers, and each of the at least one group of layers includes: a first GaN layer being formed on a base surface and having a plurality of holes which are discretely arranged and each of which has a width of 2.5 micrometers or smaller; and a second GaN layer formed over the first GaN layer.
   Preferably, the substrate according to the sixth aspect of the present invention may have one or any possible combination of the following additional features (i) to (vi).
   (i) The substrate according to the sixth aspect of the present invention may further comprise a growth suppression mask constituted by a plurality of mask elements being discretely arranged on the base surface and each having a width of 2.5 micrometers or smaller.
   (ii) In the substrate according to the sixth aspect of the present invention having the feature (i), the distance between each of the plurality of mask elements and one of the plurality of mask elements nearest to each of the plurality of mask elements is equal to or smaller than 2.5 micrometers.
   (iii) In the substrate according to the sixth aspect of the present invention having the feature (i), the plurality of mask elements cover 40 to 90% of the entire base surface.
   (iv) In the substrate according to the sixth aspect of the present invention having the feature (i), the growth suppression mask is made of a dielectric material.
   (v) The substrate according to the sixth aspect of the present invention may further comprise a conductive GaN layer which is doped with a conductive impurity and formed as an uppermost layer of the substrate.
   (vi) In the substrate according to the sixth aspect of the present invention, at least a portion of the base substrate including the surface of the base substrate is made of one of GaN, sapphire, SiC, ZnO, LiGaO₂, LiAlO₂, ZrB₂, GaAs, GaP, Ge, and Si. For example, the entire base substrate may be made of one of GaN, sapphire, SiC, ZnO, LiGaO₂, LiAlO₂, ZrB₂, GaAs, GaP, Ge, and Si. Alternatively, the base substrate may be constituted by a main portion and a GaN layer formed on the main portion, where the main portion is made of one of GaN, sapphire, SiC, ZnO, LiGaO₂, LiAlO₂, ZrB₂, GaAs, GaP, Ge, and Si.
(7) According to the seventh aspect of the present invention, there is provided a semiconductor element for use in a semiconductor element, comprising at least one group of substrate layers, where each of the at least one group of substrate layers includes: a first GaN layer being formed on a base surface and having a plurality of holes which are discretely arranged and each of which has a width of 2.5 micrometers or smaller; and a second GaN layer formed over the first GaN layer.
(8) According to the eighth aspect of the present invention, there is provided a substrate for use in a semiconductor element, which is produced through the steps of: (a) forming a plurality of substrate layers on a surface of a base substrate by performing at least one predetermined sequence of operations; and (b) separating an uppermost one of the plurality of substrate layers from the other of the plurality of substrate layers. Each of the at least one predetermined sequence of operations includes the substeps of: (a1) forming on a base surface a growth suppression mask constituted by a plurality of mask elements being discretely arranged and each having a width of 2.5 micrometers or smaller; (a2) forming on the base surface a first GaN layer having a plurality of holes by growing GaN from areas of the base surface which are not covered by the plurality of mask elements; and (a3) forming a second GaN layer over the first GaN layer. In this case, the uppermost one of the plurality of substrate layers may be a conductive GaN layer which is doped with a conductive impurity.
(9) According to the ninth aspect of the present invention, there is provided a semiconductor element comprising a substrate and semiconductor layers formed on the substrate. The substrate is one of the substrates according to the third to eighth aspects of the present invention, where the substrates according to the third to eighth aspects of the present invention may have one or any combination of the aforementioned additional features.
(10) The advantages of the present invention are as follows.

In the processes according to the first and second aspects of the present invention, a (first) growth suppression mask which is constituted by a plurality of (first) mask elements being discretely arranged and each having a width of 2.5 micrometers or smaller is formed on a surface of a base substrate; a first GaN layer having a plurality of holes is formed on the surface of the base substrate by growing GaN from areas of the surface of the base substrate which are not covered by the plurality of first mask elements; and a second GaN layer is formed over the first GaN layer by crystal growth. Therefore, the density of the nuclei of growth can be reduced compared with the conventional process. Thus, it is possible to obtain a GaN layer having a wide low-defect region, and the obtained GaN layer can be used as a reliable substrate.

When the sequence of operations of forming a growth suppression mask, a first GaN layer having a plurality of holes, and a second GaN layer is repeated two or more times in the second aspect of the present invention, it is possible to obtain a GaN layer having further lower defect density.

In addition, since the first GaN layer having a plurality of holes is formed by forming on a base surface a growth suppression mask constituted by a plurality of mask elements being discretely arranged and each having a width of 2.5 micrometers or smaller, and growing GaN from areas of the base surface which are not covered by the plurality of mask elements, the formation of the first GaN layer having the plurality of holes according to the present invention is easier than other formation processes, for example, a process in which a GaN layer having a plurality of holes is formed by first forming a GaN layer which has no holes, and then producing holes by etching or the like.

When the plurality of mask elements cover 40 to 90% of the entire base surface, the diameters of the plurality of holes formed in the first GaN layer are equivalent to the diameters of the plurality of mask elements constituting the growth suppression mask, and the plurality of holes formed in the first GaN layer occupy approximately 40 to 90% of the entire area of the first GaN layer. Therefore, when the second GaN layer is formed over the first GaN layer as above, the nuclei of growth can be effectively reduced. Thus, it is possible to obtain a GaN layer having low defect density.

In addition, when a conductive GaN layer is formed as an uppermost layer of the substrate, it is possible to obtain a conductive GaN layer having low defect density.

Further, since the semiconductor element according to the ninth aspect of the present invention is realized by forming semiconductor layers on one of the substrates according to the present invention, reliability of the semiconductor elements is high.

### DESCRIPTION OF THE DRAWINGS

Figs. 1A to 1D are diagrammatic perspective views of structures in representative stages of a process for producing a substrate as a first embodiment of the present invention.
Figs. 2A to 2C are diagrammatic perspective views of structures in representative stages of a process for producing a substrate as a second embodiment of the present invention.
Figs. 3A to 3C are diagrams schematically illustrating examples of arrangement of growth suppression mask elements.
Fig. 4 is a diagrammatic perspective view of a first variation of the substrate as the second embodiment of the present invention, where the base substrate is removed from the substrate as the second embodiment.
Figs. 5A and 5B are diagrammatic perspective views of structures in representative stages of a process for producing a second variation of the substrate as the second embodiment of the present invention.
Figs. 6A to 6D are diagrammatic perspective views of structures in representative stages of a process for producing a substrate as the concrete example II.
Figs. 7A and 7B are diagrammatic perspective views of structures in representative stages of a process for producing a substrate as the concrete example III.
Fig. 8 is a diagrammatic cross-sectional view of the concrete example IV, which is a semiconductor laser element formed by using the substrate as the concrete example II or III.

### DESCRIPTION OF PREFERRED EMBODIMENTS

Embodiments of the present invention are explained in detail below with reference to the drawings.

### First Embodiment

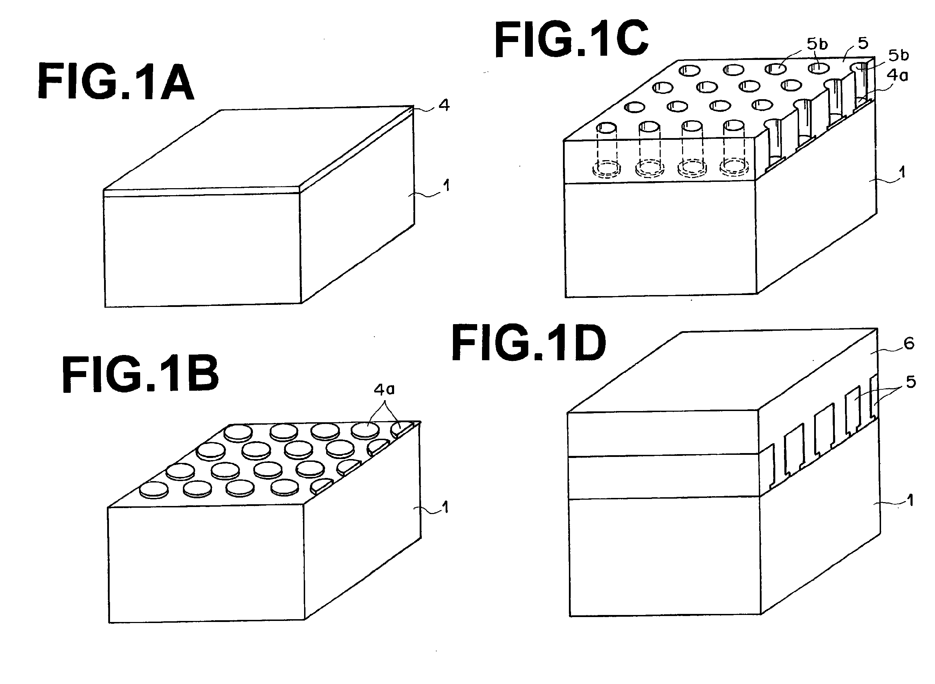

Figs. 1A to 1D are diagrammatic perspective views of structures in representative stages of a process for producing a substrate for use in a semiconductor element in the first embodiment of the present invention, where Fig. 1D shows the completed structure of the substrate as the first embodiment.

As illustrated in Fig. 1D, the substrate for use in a semiconductor element, as the first embodiment of the present invention, comprises a base substrate 1, a first GaN layer 5 formed on the base substrate 1, and a second GaN layer 6 formed over the first GaN layer 5 by crystal growth, where a plurality of holes 5b are formed in the first GaN layer 5.

The substrate as the first embodiment is produced as follows.

First, a SiO₂ film 4 is formed on the base substrate 1 as illustrated in Fig. 1A, and then a growth suppression mask 4a constituted by a plurality of dot-like (disk-like) mask elements made of SiO₂ are formed on the base substrate 1, where the plurality of dot-like (disk-like) mask elements are discretely arranged on the upper surface of the base substrate 1 as illustrated in Fig. 1B. Subsequently, the first GaN layer 5 having the plurality of holes 5b is formed over the base substrate 1 as illustrated in Fig. 1C by growing a GaN layer from the portions of the upper surface of the base substrate 1 which are not covered by the growth suppression mask 4a. Thereafter, the growth suppression mask 4a is removed, and the second GaN layer 6 is grown over the first GaN layer 5 until the upper surface of the second GaN layer 6 becomes even, as illustrated in Fig. 1D.

It is preferable that the maximum width (the maximum diameter) of each of the plurality of dot-like (disk-like) mask elements constituting the growth suppression mask 4a is 2.5 micrometers or smaller, and the growth suppression mask 4a covers 40 to 90% of the upper surface of the base substrate 1. In addition, the GaN layer 5 is formed so that the plurality of holes 5b formed in the first GaN layer 5 have the same diameters as the plurality of dot-like (disk-like) mask elements, and therefore 40 to 90% of the upper surface of the base substrate 1 is not covered by the first GaN layer 5. Further, it is preferable that the thickness of the first GaN layer 5 is equal to or greater than the diameters of the plurality of dot-like (disk-like) mask.

When the above growth suppression mask 4a is used, it is easy to form the first GaN layer 5 having the plurality of holes 5b. When the second GaN layer 6 is formed over the first GaN layer 5 by selective lateral growth, the density of the nuclei of growth can be reduced compared with the conventional ELOG substrates. In addition, defects caused by strains due to lattice mismatching with the substrate can be reduced.

Further, it is considered that when the second GaN layer 6 is grown over the first GaN layer 5 by selective lateral growth, nuclei of growth are generated on the upper surface of the first GaN layer 5 and inner surfaces of the plurality of holes 5b. When the diameters and depths of the plurality of holes 5b are set so as to satisfy a predetermined relationship, e.g., when the maximum width of the plurality of holes 5b is 1 micrometer or smaller, and the depths of the plurality of holes 5b are appropriately set corresponding to the maximum width of the plurality of holes 5b, the top portions of the plurality of holes 5b are closed with portions of the second GaN layer 6 laterally grown from nuclei of growth generated on the upper surface of the first GaN layer 5 before the plurality of holes 5b are fully filled with the second GaN layer 6. That is, it is possible to produce spaces in lower portions of the plurality of holes 5b. When such spaces exist, defects caused by strains due to a difference in the thermal expansion coefficient from the substrate can be reduced.

### Second Embodiment

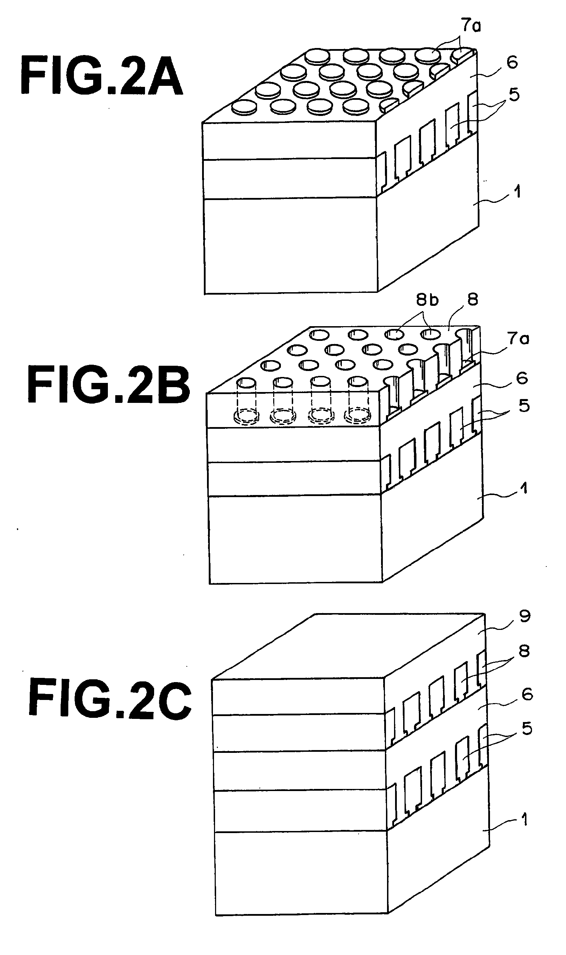

Figs. 2A to 2C are diagrammatic perspective views of structures in representative stages of a process for producing a substrate as the second embodiment of the present invention, where Fig. 2C shows the completed structure of the substrate as the second embodiment.

As illustrated in Figs. 2A to 2C, the substrate as the second embodiment is produced by performing again the operations for producing the substrate as the first embodiment, on the substrate as the first embodiment. That is, the substrate as the second embodiment is produced as follows.

First, another growth suppression mask 7a is formed on the second GaN layer 6 in the substrate as the first embodiment in a similar manner to the manner in which the growth suppression mask 4a is formed on the base substrate 1, as illustrated in Fig. 2A. Then, a third GaN layer 8 having a plurality of holes 8b is formed on the second GaN layer 6 by using the growth suppression mask 7a, as illustrated in Fig. 2B. Subsequently, a fourth GaN layer 9 is formed by selective lateral growth over the third GaN layer 8 as illustrated in Fig. 2C.

When formation of a first GaN layer having a plurality of holes and formation of a second GaN layer over the first GaN layer having the plurality of holes are repeated, it is possible to obtain a GaN layer in which defects are further reduced. The formation of the first and second GaN layers may be repeated more than two times.

The growth suppression mask may be made of any other material which can suppress growth of GaN. For example, growth suppression mask may be made of another dielectric material such as alumina (Al₂O₃) or silicon nitride (SiN), instead of SiO₂.

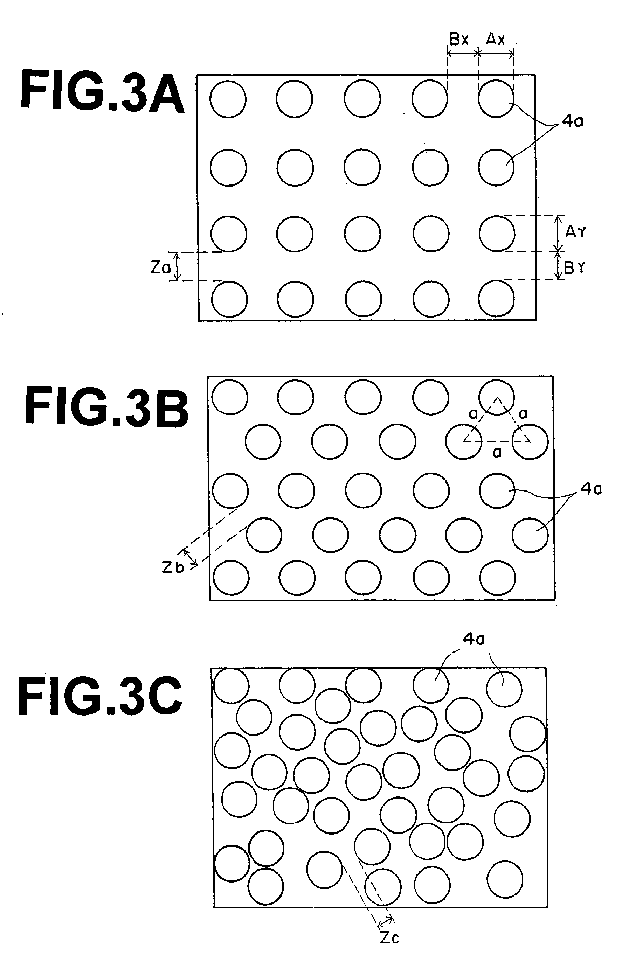

Figs. 3A to 3C are diagrammatic plan views of preferable examples of a base on which a GaN layer having a plurality of holes are to be formed. That is, Figs. 3A to 3C schematically show preferable examples of arrangement of growth suppression mask elements. In the example of Fig. 3A, the dot-like mask elements are arranged four-fold symmetrically so that the width Ax of each dot-like mask element and the interval Bx between adjacent dot-like mask elements in the lateral direction are respectively identical to the width Ay of each dot-like mask element and the interval By between adjacent dot-like mask elements in the longitudinal direction. In the example of Fig. 3B, the dot-like mask elements are arranged six-fold symmetrically so that every three adjacent dot-like mask elements form an equilateral triangle. In the example of Fig. 3C, the dot-like mask elements are randomly arranged. However, in any arrangement, it is preferable that the minimum interval between each dot-like mask element and a nearest dot-like mask element (e.g., the intervals Za, Zb, and Zc respectively indicated in Figs. 3A, 3B, and 3C) is 2.5 micrometers or smaller.

### Variations of Embodiments

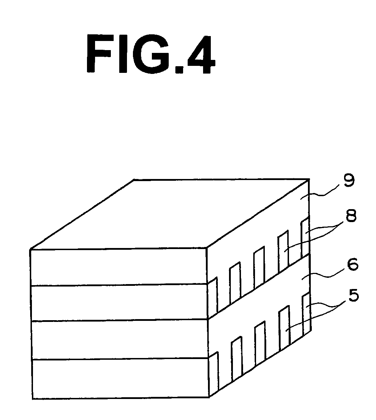

(1) Although the dot-like mask elements have a circular form in the above example, the dot-like mask elements may have a polygonal form or an arbitrary form.
(2) Preferably, at least a portion of the base substrate 1 including the surface of the base substrate 1, on which the growth suppression mask is formed, is made of one of GaN, sapphire, SiC, ZnO, LiGaO₂, LiAlO₂, ZrB₂, GaAs, GaP, Ge, and Si. For example, the entire base substrate 1 may be made of one of GaN, sapphire, SiC, ZnO, LiGaO₂, LiAlO₂, ZrB₂, GaAs, GaP, Ge, and Si. Alternatively, the base substrate may be constituted by a main portion made of one of GaN, sapphire, SiC, ZnO, LiGaO₂, LiAlO₂, ZrB₂, GaAs, GaP, Ge, and Si, and a GaN layer formed on the main portion.
(3) Although the constructions of the first and second embodiments each including the layers from the base substrate 1 to the uppermost GaN layer as illustrated in Figs. 1D and 2C may be used as a substrate, it is possible to remove the base substrate 1 from each of the constructions. For example, Fig. 4 shows a first variation of the substrate as the second embodiment. In the substrate of Fig. 4, the base substrate 1 is removed from the substrate as the second embodiment.
(4) Although the GaN layers are undoped in the first and second embodiments, n-type or p-type conductive GaN layers, instead of the undoped GaN layers, may be formed by doping the GaN layers with a conductive impurity. In this case, a conductive substrate for use in a semiconductor element can be obtained by removing the base substrate 1 after formation of the conductive GaN layers, for example, as illustrated in Fig. 4.

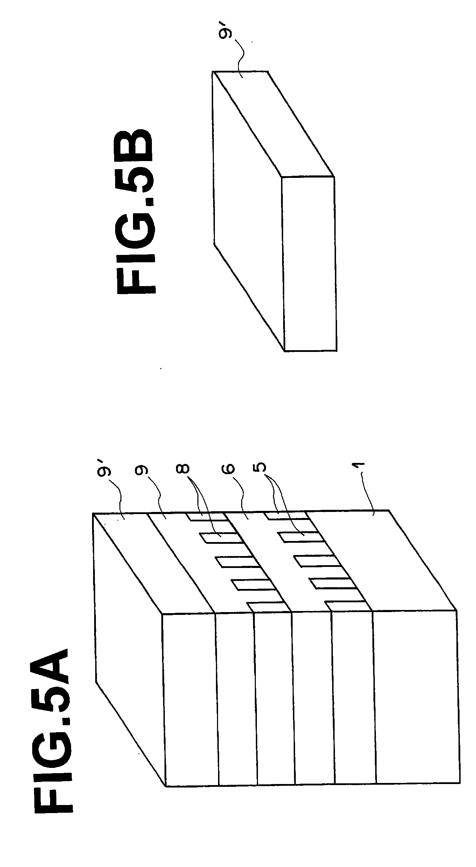

(5) Figs. 5A and 5B are diagrammatic perspective views of structures in representative stages of a process for producing a second variation of the substrate as the second embodiment of the present invention, where Fig. 5B shows the second variation of the substrate as the second embodiment.

The substrate as the second variation of the second embodiment is produced as follows.

First, as illustrated in Fig. 5A, an n-type or p-type conductive GaN layer 9' which is doped with a conductive impurity and has a thickness of about 100 to 200 micrometers is formed on the GaN layer 9 in the construction of Fig. 2C. Then, the substrate as the second variation of the second embodiment is obtained by removing from the structure of Fig. 5A the layers from the base substrate 1 to the GaN layer 9, as illustrated in Fig. 5B.

### Advantages of Embodiments

(1) In the substrates as the first and second embodiments and their variations, defect densities in the uppermost GaN layers are reduced. Therefore, when semiconductor elements are produced by forming semiconductor layers on these substrates, reliability of the semiconductor elements can be increased.
(2) When semiconductor elements such as semiconductor laser elements are produced by forming semiconductor layers (for example, including an active layer) on a conductive substrate, an electrode can be formed on the back surface of the substrate. Therefore, processes for producing the semiconductor elements can be simplified.
(3) Since the defect densities in the substrates according to the present invention are low, the substrates according to the present invention are reliable, and can be used in production of semiconductor elements and optical or electronic devices in the fields of high-speed, information processing, image processing, communications, laser measurement, medicine, printing, and the like, where the semiconductor elements and the optical or electronic devices include field effect transistors, semiconductor laser devices, semiconductor optical amplifiers, light emitting devices, optical detectors, and the like.

### Concrete Examples

Concrete examples of processes for producing the substrates as the embodiments of the present invention are explained below.

In the following concrete examples I to IV, materials used in the growth of the layers are trimethyl gallium (TMG), trimethyl aluminum (TMA), trimethyl indium (TMI), and ammonia. In addition, silane gas is used as n-type dopant gas, and cycropentadienyl magnesium (Cp₂Mg) is used as p-type dopant gas.

### Concrete Example I

The concrete example I is a concrete example of the substrate as the first embodiment of the present invention illustrated in Figs. 1A to 1D.

The substrate as the concrete example I is produced as follows.

First, as illustrated in Fig. 1A, a SiO₂ film 4 having a thickness of about 0.5 micrometers is formed on a (0001) face of a base substrate 1 made of sapphire, by plasma CVD (chemical vapor deposition) using SiH₄ gas and N₂O gas.

Subsequently, a resist pattern (not shown) of a plurality of dot-like areas having a diameter of 2.5 micrometers or smaller and being arranged with a pitch equivalent to the dot diameter is formed on the SiO₂ film 4 by photolithography, and then the SiO₂ film 4 is etched by RIE (reactive ion etching) dry etching using the resist pattern and CHF₃/O₂ gas. Thereafter, the resist pattern is removed by O₂ plasma ashing. Thus, a growth suppression mask 4a made of SiO₂ and patterned to have a plurality of discretely arranged dot-like areas is formed as illustrated in Fig. 1B. At this time, the growth suppression mask 4a occupies 40 to 90% of the entire area of the upper surface of the base substrate 1.

Next, a GaN buffer layer having a thickness of 20 nanometers (not shown) is grown at 500°C, and a first GaN layer 5 having a thickness of about 3 micrometers is grown at 1,050°C from exposed portions of the sapphire base substrate 1 (i.e., the portions of the sapphire base substrate 1 which are not covered by the growth suppression mask 4a) over the GaN buffer layer. Since the first GaN layer 5 is not grown from the growth suppression mask 4a, it has the plurality of holes 5b as illustrated in Fig. 1C. In addition, the first GaN layer 5 is also grown to some extent in lateral directions from the exposed portions of the sapphire base substrate 1 so that it is also formed over the edge portions of each of the plurality of dot-like (disk-like) mask elements constituting the growth suppression mask 4a. Therefore, the diameters of the plurality of holes 5b are slightly smaller than the diameters of the plurality of dot-like (disk-like) mask elements. At this time, it is preferable that the thickness of the first GaN layer 5 is equal to or greater than the diameters of the plurality of holes 5b.

Thereafter, the growth suppression mask 4a made of SiO₂ is etched off with buffered hydrofluoric acid, and then a second GaN layer 6 is grown by MOCVD (metal organic chemical vapor deposition) at 1,080°C. At this time, the crystal growth of GaN is continued until regions above the plurality of holes 5b are closed by growth of GaN in lateral directions, and the upper surface of the second GaN layer 6 becomes even, as illustrated in Fig. 1D. Thus, the second GaN layer 6 having a low defect density is obtained.

The present inventor has measured the etch pit density of the substrate formed as above. In the measurement, the etch pit density is counted after the substrate is dipped in an etching solution. The measured etch pit density of the substrate as the concrete example I is two to four orders of magnitude smaller than the etch pit densities of the substrates produced by the conventional production process.

### Concrete Example II

The concrete example II is a concrete example of the substrate as the second embodiment of the present invention illustrated in Figs. 2A to 2C. In the concrete examples II to IV, the base substrate 1 includes a main portion and a GaN layer formed on the main portion.

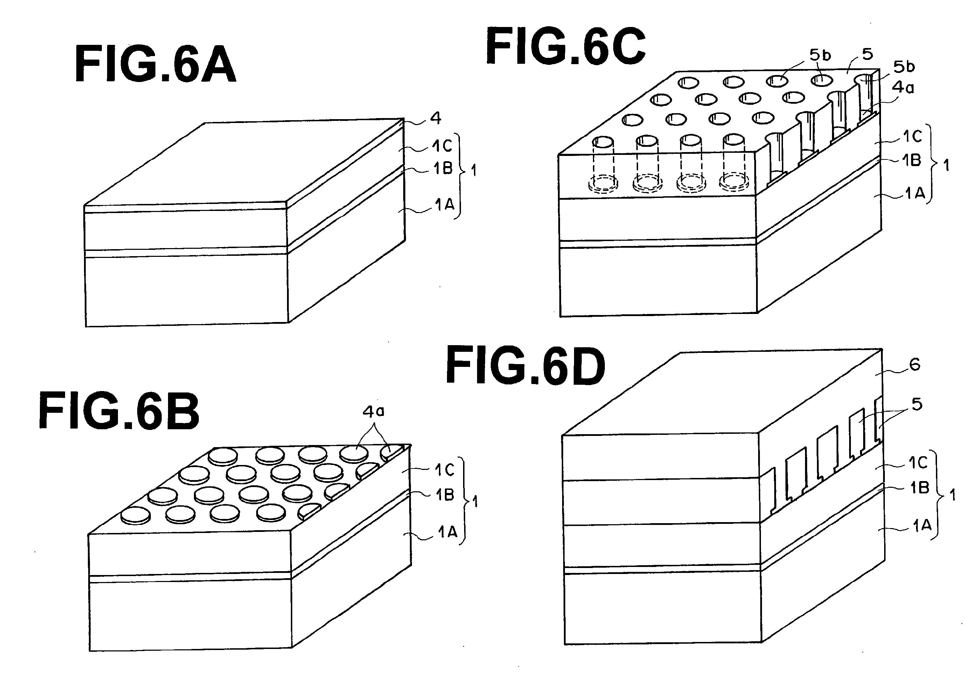

A process for producing the substrate as the concrete example II is explained below with reference to Figs. 6A to 6D, which are diagrammatic perspective views of structures in representative stages of a process for producing a substrate as the concrete example II.

First, as illustrated in Fig. 6A, a GaN buffer layer 1B having a thickness of about 20 nm is formed on a (0001) face of a main portion 1A made of sapphire, by organometallic vapor phase epitaxy at 500°C, and then a GaN layer 1C having a thickness of about 2 micrometers is formed at 1,050°C. Thus, a base substrate 1 is obtained.

Thereafter, a SiO₂ film 4 having a thickness of about 0.5 micrometers is formed on the base substrate 1 by plasma CVD using SiH₄ gas and N₂O gas.

Subsequently, a resist pattern (not shown) of a plurality of dot-like areas having a diameter of 2.5 micrometers or smaller and being arranged with a pitch equivalent to the dot diameter is formed on the SiO₂ film 4 by photolithography, and then the SiO₂ film 4 is etched by RIE dry etching using the resist pattern and CHF₃/O₂ gas. Thereafter, the resist pattern is removed by O₂ plasma ashing. Thus, a growth suppression mask 4a made of SiO₂ and patterned to have a plurality of discretely arranged dot-like areas is formed as illustrated in Fig. 6B. At this time, the growth suppression mask 4a occupies 40 to 90% of the entire area of the upper surface of the GaN layer 1C.

Next, a GaN layer 5 is grown at 1,050 °C from exposed portions of the GaN layer 1C (i.e., the portions of the GaN layer 1C which are not covered by the growth suppression mask 4a). Since GaN is not grown from the growth suppression mask 4a, the first GaN layer 5 has the plurality of holes 5b as illustrated in Fig. 6C. In addition, GaN is also grown to some extent in lateral directions from the exposed portions of the GaN layer 1C so that the first GaN layer 5 is also formed over the edge portions of each of the plurality of dot-like (disk-like) mask elements constituting the growth suppression mask 4a. Therefore, the diameters of the plurality of holes 5b are slightly smaller than the diameters of the plurality of dot-like (disk-like) mask elements.

Thereafter, the growth suppression mask 4a made of SiO₂ is etched off with buffered hydrofluoric acid, and then a second GaN layer 6 is grown at 1,050°C. At this time, the crystal growth of GaN is continued until regions above the plurality of holes 5b are closed by growth of GaN in lateral directions and the upper surface of the second GaN layer 6 becomes even, as illustrated in Fig. 6D. Thus, the second GaN layer 6 having a low defect density is obtained.

Further, by the same steps as shown in Figure 6b through Figure 6d, another growth suppression mask 7a is formed on the GaN layer 6 in a similar manner to the manner in which the growth suppression mask 4a is formed on the base substrate 1, as illustrated in Fig. 2A. Then, a third GaN layer 8 having a plurality of holes 8b is formed over the GaN layer 6 by using the growth suppression mask 7a, as illustrated in Fig. 2B. Subsequently, a fourth GaN layer 9 is formed over the third GaN layer 8 as illustrated in Fig. 2C. It is possible to obtain a substrate having a reduced defect density by continuing the crystal growth until the upper surface of the GaN layer 9 becomes even.

The present inventor has measured the etch pit density of the substrate formed as above. The measured etch pit density of the substrate as the concrete example II is two to six orders of magnitude smaller than the etch pit densities of the substrates produced by the conventional production process.

Although the growth suppression masks 4a and 7a are removed in the concrete examples I and II, alternatively, the growth suppression masks 4a and 7a may not be removed, and the upper GaN layers 6 and 9 may be formed over the growth suppression masks 4a and 7a. That is, the growth suppression masks 4a and 7a may be embedded in the completed substrates.

### Concrete Example III

The concrete example III is another concrete example of the substrate as the second embodiment of the present invention illustrated in Figs. 2A to 2C. In the concrete example III, the growth suppression mask 7a is not removed.

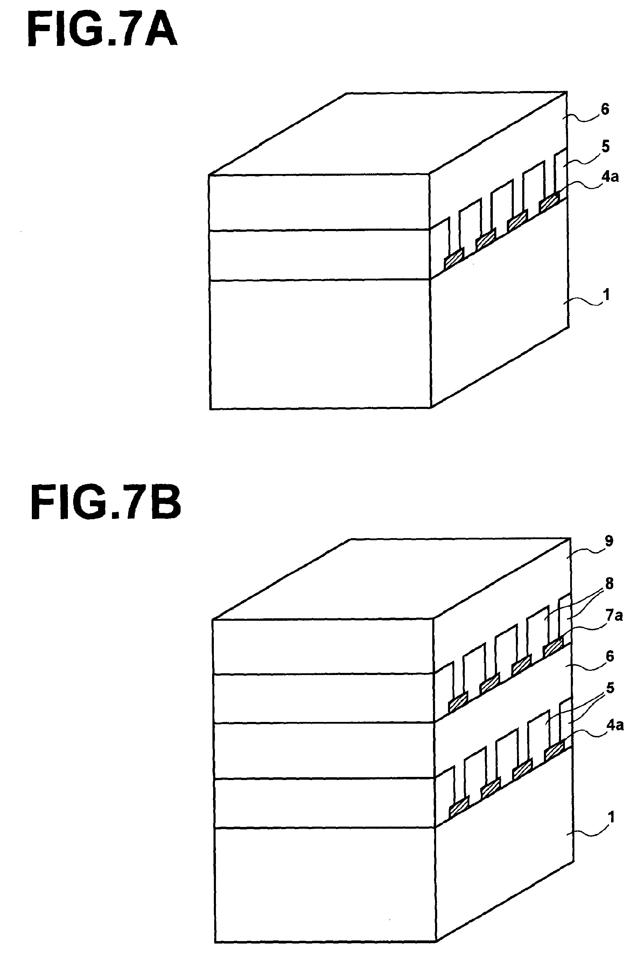

A process for producing the substrate as the concrete example III is explained below with reference to Figs. 7A and 7B, which are diagrammatic perspective views of structures in representative stages of a process for producing a substrate as the concrete example III.

First, as illustrated in Fig. 6A, a base substrate 1 is produced by forming by MOCVD a GaN buffer layer 1B and a GaN layer 1C on a main portion 1A made of SiC.

Then, a SiO₂ film 4 having a thickness of about 0.5 micrometers is formed on the GaN layer 1C of the base substrate 1 by plasma CVD using SiH₄ gas and N₂O gas.

Subsequently, a resist pattern (not shown) of a plurality of dot-like areas having a diameter of 2.5 micrometers or smaller and being arranged with a pitch equivalent to the dot diameter is formed on the SiO₂ film 4 by photolithography, and then the SiO₂ film 4 is etched by RIE (reactive ion etching) dry etching using the resist pattern and CHF₃/O₂ gas. Thereafter, the resist pattern is removed by O₂ plasma ashing. Thus, a growth suppression mask 4a made of SiO₂ and patterned to have a plurality of discretely arranged dot-like areas is formed as illustrated in Fig. 6B. At this time, the growth suppression mask 4a occupies 40 to 90% of the entire area of the upper surface of the GaN layer 1C.

Next, a first GaN layer 5 having a thickness of about 3 micrometers is grown at 1,050 °C from exposed portions of the GaN layer 1C (i.e., the portions of the GaN layer 1C which are not covered by the growth suppression mask 4a). Since GaN is not grown from the growth suppression mask 4a, the first GaN layer 5 has the plurality of holes 5b as illustrated in Fig. 6C.

Thereafter, a second GaN layer 6 is grown by MOCVD at 1,080°C. At this time, the crystal growth of GaN is continued until regions above the plurality of holes 5b are closed by growth of GaN in lateral directions, and the upper surface of the second GaN layer 6 becomes even, as illustrated in Fig. 7A. Thus, the second GaN layer 6 having a low defect density is obtained.

Further, another growth suppression mask 7a is formed on the second GaN layer 6 in a similar manner to the manner in which the growth suppression mask 4a is formed on the base substrate 1. Then, a third GaN layer 8 having a plurality of holes 8b is formed over the GaN layer 6 by using the growth suppression mask 7a. Subsequently, a fourth GaN layer 9 is formed over the third GaN layer 8. It is possible to obtain a substrate having a reduced defect density by continuing the crystal growth until the upper surface of the GaN layer 9 becomes even as illustrated in Fig. 7B.

The present inventor has measured the etch pit density of the substrate formed as above. The measured etch pit density of the substrate as the concrete example III is four to six orders of magnitude smaller than the etch pit densities of the substrates produced by the conventional production process.

### Concrete Example IV

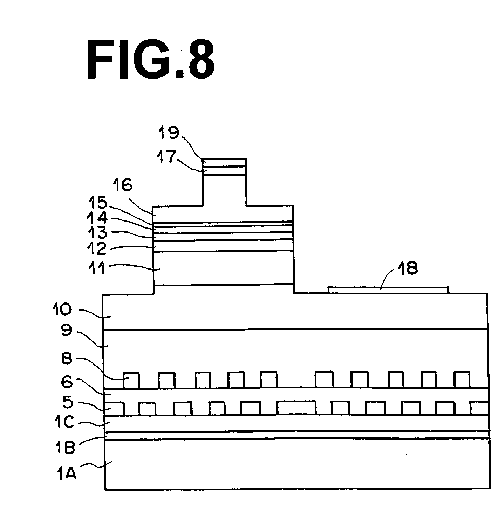

The concrete example IV is a concrete example of a semiconductor laser element formed by using the substrate of the concrete example II. Fig. 8 is a diagrammatic cross-sectional view of the semiconductor laser element as the concrete example IV.

As illustrated in Fig. 8, an n-type GaN contact layer 10, an n-type Ga_{1-z1}Al_{z1}N (2.5 nm)/GaN (2.5 nm) superlattice cladding layer 11, an n-type Ga_{1-z2}Al_{z2}N optical waveguide layer 12, an Inₓ₂Ga₁₋ₓ₂N (Si-doped)/Inx1Ga₁-x1N multiple-quantum-well active layer 13 (0.5>x1>x2 ≥ 0), a p-type Ga_{1-z3}Al_{z3}N carrier blocking layer 14 (1 ≥ zl>z3>z2 ≥ 0), a p-type Ga_{1-z2}Al_{z2}N optical waveguide layer 15, a p-type Ga_{1-z1}Al_{z1}N (2.5 nm)/GaN (2.5 nm) superlattice cladding layer 16, and a p-type GaN contact layer 17 are formed on the GaN layer 9 in the substrate of the concrete example II.

Subsequently, a first SiO₂ insulation film (not shown) and a first resist layer (not shown) are formed on the p-type GaN contact layer 17, and regions of the first resist layer and the first SiO₂ insulation film other than first stripe regions of the first resist layer and the first SiO₂ insulation film having a width of about 30 micrometers are removed by conventional lithography. Then, the regions of the layered structures formed as above on both sides of the first stripe regions are etched to a mid-thickness of the p-type Ga₁₋ _{z1}Al_{z1}N (2.5 nm)/GaN (2.5 nm) superlattice cladding layer 16 by selective etching using RIE, where the thickness of the remaining superlattice cladding layer 16 is determined so as to realize an index-guided structure. Thereafter, the remaining regions of the first resist layer and the first SiO₂ insulation film are removed.

Next, a second SiO₂ insulation film (not shown) and a second resist layer (not shown) are formed over the layered structures formed as above, regions of the second resist layer and the second SiO₂ insulation film other than second stripe regions of the second resist layer and the second SiO₂ insulation film are removed, where the second stripe regions are located corresponding to the first stripe regions and 20 micrometers wider than the first stripe regions on each side of the first stripe regions. Then, the regions of the layered structures on both sides of the second stripe regions are etched by RIE until the n-type GaN contact layer 10 is exposed.

Thereafter, by using conventional lithography, an n electrode 18 made of Ti/Al is formed on the n-type GaN contact layer 10, and a p electrode 19 made of Ni/Au is formed on the remaining stripe region of the p-type GaN contact layer 17. Subsequently, the substrate is polished and cleaved so as to form resonator surfaces. Then, a high reflectance coating and a low reflectance coating are applied to the resonator surfaces produced by the cleavage, and the layered structure thus formed is formed into a chip of a semiconductor laser element.

Since, in the above semiconductor laser element, a wide stripe structure is formed on the low-defect GaN layer 9, the reliability of the semiconductor laser element is high even in high output power operations.

When the composition of the active layer is appropriately controlled, the oscillation wavelength of the semiconductor laser element as the concrete example IV can be controlled in the range of 380 to 550 nm.

Although the semiconductor laser element as the concrete example IV is an index-guided semiconductor laser element having a ridge structure and a large stripe width of 30 micrometers, the substrates according to the present invention can also be used in other semiconductor elements including other semiconductor laser elements. Such semiconductor laser elements may include index-guided semiconductor laser elements having an internal index-guided structure and index-guided semiconductor laser elements having a buried ridge structure. In addition, the substrates according to the present invention can be further used for production of index-guided semiconductor laser elements which have a ridge structure and a stripe width of about 1 to 2 micrometers and oscillate in a fundamental transverse mode.

### Additional Matters

The conductivity types of the semiconductor layers in the concrete examples I to IV may be inverted. That is, the n-type and the p-type may be exchanged.

## Claims

1. A process for producing a substrate for use in a semiconductor element, comprising the steps of:
(a) forming on a surface of a base substrate a first growth suppression mask constituted by a plurality of first mask elements being discretely arranged and each having a width of 2.5 micrometers or smaller;
(b) forming on said surface of the base substrate a first GaN layer having a plurality of holes by growing GaN from areas of the surface of the base substrate which are not covered by said plurality of first mask elements; and
(c) forming a second GaN layer over said first GaN layer.

2. A process according to claim 1, further comprising, between said steps (b) and (c), a step for removing said first growth suppression mask.

3. A process according to claim 1, further comprising, after said step (c), the steps of,
(d) forming on said second GaN layer a second growth suppression mask constituted by a plurality of second mask elements being discretely arranged and each having a width of 2.5 micrometers or smaller,
(e) forming on said second GaN layer a third GaN layer having a plurality of holes by growing GaN from areas of the second GaN layer which are not covered by said plurality of second mask elements, and
(f) forming a fourth GaN layer over said third GaN layer.

4. A process according to claim 3, further comprising, between said steps (e) and (f), a step for removing said second growth suppression mask.

5. A process for producing a substrate for use in a semiconductor element by formation of a plurality of substrate layers on a surface of a base substrate, where said formation is realized by at least one predetermined sequence of operations, and each of said at least one predetermined sequence of operations includes the steps of:
(a) forming on a base surface a growth suppression mask constituted by a plurality of mask elements being discretely arranged and each having a width of 2.5 micrometers or smaller;
(b) forming on said base surface a first GaN layer having a plurality of holes by growing GaN from areas of the base surface which are not covered by said plurality of mask elements; and
(c) forming a second GaN layer over said first GaN layer.

6. A process according to claim 5, further comprising, between said steps (b) and (c), a step for removing said growth suppression mask.

7. A process according to claim 5, wherein a distance between each of said plurality of mask elements and one of the plurality of mask elements nearest to said each of said plurality of mask elements is equal to or smaller than 2.5 micrometers.

8. A process according to claim 5, wherein said plurality of mask elements cover 40 to 90% of the entire base surface.

9. A process according to claim 5, wherein said growth suppression mask is made of a dielectric material.

10. A process according to claim 5, further comprising a step for forming as an uppermost layer of said substrate a conductive GaN layer which is doped with a conductive impurity.

11. A process according to claim 5, wherein at least a portion of the base substrate including said surface of the base substrate is made of one of GaN, sapphire, SiC, ZnO, LiGaO₂, LiAlO₂, ZrB₂, GaAs, GaP, Ge, and Si.

12. A process according to claim 5, further comprising a step for removing said base substrate.

13. A process according to claim 5, further comprising a step of separating an uppermost one of said plurality of substrate layers from other ones of said plurality of substrate layers.

14. A semiconductor element comprising:
a substrate; and
semiconductor layers formed on the substrate;
wherein said substrate includes a base substrate and a plurality of substrate layers formed on said base substrate,
said plurality of substrate layers include at least one group of layers, and
each of the at least one group of layers includes,
a first GaN layer being formed on a base surface and having a plurality of holes which are discretely arranged and each of which has a width of 2.5 micrometers or smaller, and
a second GaN layer formed over said first GaN layer.

15. A semiconductor element according to claim 14, wherein each of the at least one group of layers further includes a growth suppression mask constituted by a plurality of mask elements being discretely arranged on said base surface and each having a width of 2.5 micrometers or smaller.

16. A semiconductor element according to claim 15, wherein a distance between each of said plurality of mask elements and one of the plurality of mask elements nearest to said each of said plurality of mask elements is equal to or smaller than 2.5 micrometers.

17. A semiconductor element according to claim 15, wherein said plurality of mask elements cover 40 to 90% of the entire base surface.

18. A semiconductor element according to claim 15, wherein said growth suppression mask is made of a dielectric material.

19. A semiconductor element according to claim 14, wherein said substrate further includes a conductive GaN layer which is doped with a conductive impurity and formed as an uppermost layer of said substrate.

20. A semiconductor element according to claim 14, wherein at least a portion of the base substrate including said surface of the base substrate is made of one of GaN, sapphire, SiC, ZnO, LiGaO₂, LiAlO₂, ZrB₂, GaAs, GaP, Ge, and Si.

21. A semiconductor element comprising:
a substrate; and
semiconductor layers formed on the substrate;
wherein said substrate includes a plurality of substrate layers,
said plurality of substrate layers include at least one group of layers, and
each of the at least one group of layers includes,
a first GaN layer being having a plurality of holes which are discretely arranged and each of which has a width of 2.5 micrometers or smaller, and
a second GaN layer formed over said first GaN layer.

22. A semiconductor element, comprising:
a substrate; and
semiconductor layers formed on the substrate;
wherein said substrate is produced through the steps of:
(a) forming a plurality of substrate layers on a surface of a base substrate by performing at least one predetermined sequence of operations; and
(b) separating an uppermost one of said plurality of substrate layers from the other of said plurality of substrate layers; and
each of said at least one predetermined sequence of operations includes the substeps of,
(a1) forming on a base surface a growth suppression mask constituted by a plurality of mask elements being discretely arranged and each having a width of 2.5 micrometers or smaller,
(a2) forming on said base surface a first GaN layer having a plurality of holes by growing GaN from areas of the base surface which are not covered by said plurality of mask elements, and
(a3) forming a second GaN layer over said first GaN layer.

23. A substrate for use in a semiconductor element, comprising:
a base substrate;
a first GaN layer having a plurality of holes which are discretely arranged and being formed on a surface of said base substrate by growing GaN from areas of the surface of the base substrate which are not covered by a plurality of first mask elements constituting a first growth suppression mask, being discretely arranged, and each having a width of 2.5 micrometers or smaller; and
a second GaN layer formed over said first GaN layer.

24. A substrate according to claim 23, further comprising,
a third GaN layer having a plurality of holes which are discretely arranged and being formed on a surface of said second GaN layer by growing GaN from areas of the surface of the second GaN layer which are not covered by a plurality of second mask elements constituting a second growth suppression mask, being discretely arranged, and each having a width of 2.5 micrometers or smaller, and
a fourth GaN layer formed over said third GaN layer.

25. A substrate for use in a semiconductor element, comprising:
a base substrate; and
a plurality of substrate layers formed on said base substrate;
wherein said plurality of substrate layers include at least one group of layers, and
each of the at least one group of layers includes,
a first GaN layer having a plurality of holes which are discretely arranged and being formed on a base surface by growing GaN from areas of the base surface which are not covered by a plurality of mask elements constituting a growth suppression mask, being discretely arranged, and each having a width of 2.5 micrometers or smaller, and
a second GaN layer formed over said first GaN layer.

26. A substrate according to claim 25, wherein a distance between each of said plurality of mask elements and one of the plurality of mask elements nearest to said each of said plurality of mask elements is equal to or smaller than 2.5 micrometers.

27. A substrate according to claim 25, wherein said plurality of mask elements cover 40 to 90% of the entire base surface.

28. A substrate according to claim 25, wherein said growth suppression mask is made of a dielectric material.

29. A substrate according to claim 25, further comprising a conductive GaN layer which is doped with a conductive impurity and formed as an uppermost layer of said substrate.

30. A substrate according to claim 25, wherein at least a portion of the base substrate including said surface of the base substrate is made of one of GaN, sapphire, SiC, ZnO, LiGaO₂, LiAlO₂, ZrB₂, GaAs, GaP, Ge, and Si.

31. A semiconductor element for use in a semiconductor element, comprising at least one group of substrate layers, where each of the at least one group of substrate layers includes:
a first GaN layer having a plurality of holes which are discretely arranged and being formed on a base surface by growing GaN from areas of the base surface which are not covered by a plurality of mask elements constituting a growth suppression mask, being discretely arranged, and each having a width of 2.5 micrometers or smaller; and
a second GaN layer formed over said first GaN layer.

32. A substrate for use in a semiconductor element, comprising:
a base substrate; and
a plurality of substrate layers formed on said base substrate;
wherein said plurality of substrate layers include at least one group of layers, and
each of the at least one group of layers includes,
a first GaN layer being formed on a base surface and having a plurality of holes which are discretely arranged and each of which has a width of 2.5 micrometers or smaller, and
a second GaN layer formed over said first GaN layer.

33. A substrate according to claim 32, further comprising a growth suppression mask constituted by a plurality of mask elements being discretely arranged on said base surface and each having a width of 2.5 micrometers or smaller.

34. A substrate according to claim 33, wherein a distance between each of said plurality of mask elements and one of the plurality of mask elements nearest to said each of said plurality of mask elements is equal to or smaller than 2.5 micrometers.

35. A substrate according to claim 33, wherein said plurality of mask elements cover 40 to 90% of the entire base surface.

36. A substrate according to claim 33, wherein said growth suppression mask is made of a dielectric material.

37. A substrate according to claim 32, further comprising a conductive GaN layer which is doped with a conductive impurity and formed as an uppermost layer of said substrate.

38. A substrate according to claim 32, wherein at least a portion of the base substrate including said surface of the base substrate is made of one of GaN, sapphire, SiC, ZnO, LiGaO₂, LiAlO₂, ZrB₂, GaAs, GaP, Ge, and Si.

39. A semiconductor element for use in a semiconductor element, comprising at least one group of substrate layers, where each of the at least one group of substrate layers includes:
a first GaN layer being formed on a base surface and having a plurality of holes which are discretely arranged and each of which has a width of 2.5 micrometers or smaller; and
a second GaN layer formed over said first GaN layer.

40. A substrate for use in a semiconductor element, which is produced through the steps of:
(a) forming a plurality of substrate layers on a surface of a base substrate by performing at least one predetermined sequence of operations; and
(b) separating an uppermost one of said plurality of substrate layers from the other of said plurality of substrate layers; and
each of said at least one predetermined sequence of operations includes the substeps of,
(a1) forming on a base surface a growth suppression mask constituted by a plurality of mask elements being discretely arranged and each having a width of 2.5 micrometers or smaller,
(a2) forming on said base surface a first GaN layer having a plurality of holes by growing GaN from areas of the base surface which are not covered by said plurality of mask elements, and
(a3) forming a second GaN layer over said first GaN layer.
